# EUROPEAN PATENT APPLICATION

(11) **EP 2 330 621 A1**
(43) Date of publication of application: **08.06.2011**
(21) Application number: 10014069.8
(22) Date of filing: 28.10.2010
(51) Int. Cl.: H01L 21/98, H01L 25/10, H01L 25/16, H01L 25/18, H01L 23/31, H01L 23/498

(54) **Package on package method, structure and associated PCB system**

(30) Priority: 02.12.2009 TW 98141237
(71) Applicant: MStar Semiconductor, Inc, Taiwan 302 (TW)
(72) Inventor: Yang, Chih-An, Hsinchu Hsien Taiwan 302 (CN); Pan, Yi-Hsiang, Hsinchu Hsien Taiwan 302 (CN); Chang, Ming-Chung, Hsinchu Hsien Taiwan 302 (CN); Chang, Chu-Chia, Hsinchu Hsien Taiwan 302 (CN); Chang, Chih-Hao, Hsinchu Hsien Taiwan 302 (CN); Hsu, Wei-Lun, Hsinchu Hsien Taiwan 302 (CN)
(74) Representative: Mollekopf, Gerd Willi

(57) **Abstract**

A package on package stacking method is provided. The package on package stacking method includes attaching a lead frame (24) and a substrate (22); attaching an integrated circuit (IC, 34) and the substrate, and electrically connecting the IC (34) and the lead frame (24); and packaging the IC (34), a part of the substrate (22) and a part of the lead frame (24), and exposing a surface mount joint to form a concave package (42).

## Description

### FIELD OF THE INVENTION

The present invention relates to an integrated circuit package method, structure and associated PCB system, and more particularly to a package on package method, structure and associated PCB system.

### BACKGROUND OF THE INVENTION

The integrated circuit (IC) package belongs to the post process of the semiconductor industry, where ICs on a chip are separated, die bonded, finger attached and encapsulated. The product (package) mainly provides a connection interface. The internal electric signal can be connected with the system via the packaging material, such as fingers. The package also prevents silicon chips from destruction and erosion by external force, water, humidity and chemicals. The common IC packaging methods include dual inline package (DIP), plastic quad flat package (PQFP), plastic flat package (PFP), pin grid array package (PGA), ball grid array package (BGA) and etc.

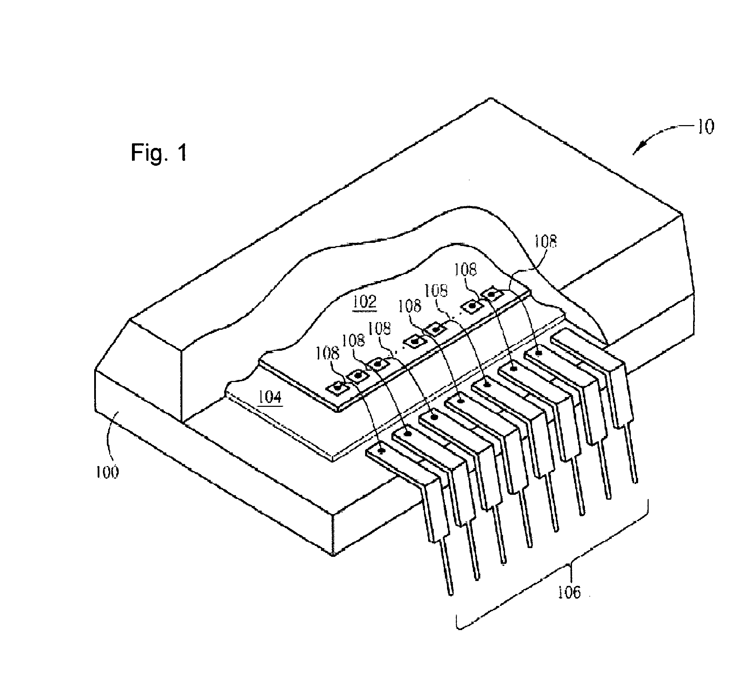

IC package comprises an IC, a lead frame and an encapsulation shell. FIG. 1 shows a profile diagram of a conventional IC package 10. The conventional IC package 10 comprises an IC 102, a die paddle 104, a finger 106, a gold wire 108 and an encapsulation shell 100. The IC 102 is the kernel unit of the IC package 10 for the analog or the digital signal processing. The die paddle 104 and the finger 106 form a lead frame to hold the IC 102 and the gold wire 108, so that signals can be transmitted. The encapsulation shell 100 fills the cavity to protect the IC package 10. The material of the encapsulation shell 100 can be cermet or plastic, such as epoxy molding compound (EMC). In general, the inductance values of the gold wire 108 and the finger 106 are about 1 nH/mm and 0.8 nH/mm. For example, in the 256-pin low profile quad flat package (LPQFP), the lengths of the gold wire 108 and the finger 106 are 3 mm and 8 to 10 mm, which form an effective inductance approximately with 10.2 nH.

Generally, ICs can be packaged in the system in package (SIP) in many ways, such as side-by-side package, package on package (PoP) and quad flat package (QFP). Each method has its uniqueness. The PoP technique is particularly effective in reducing the package size and is a better choice for the SIP demanding a small package size, while the side-by-side package is often used in those ICs with large power consumption.

Compared with a system design with a plurality of ICs on a printed circuit board (PCB), the package of implementing SIP method can be smaller, lighter and thinner. Another advantage is that the SIP implementation can reduce or eliminate the demand for the design with high speed circuits by the system manufacturer. The other related advantage is that the noise of the electromagnetic interference (EMI) generated by the SIP is smaller.

Generally the noise of an embedded system on the PCB is about 90 dB. The SIP technique can reduce the noise enormously to around 60 dB. The improvement mainly results from the short length of the connection wires on the SIP and the adequate power design. Another advantage is that the SIP reduces much peak voltage, so the SIP can simplify the end product design of the system manufacturer.

Since the PCB space is saved by the SIP, the cost of the PCB is additionally reduced. Similarly, since the devices in the SIP get sufficient tests, the test time by the system manufacturer can be saved, and the SIP also reduces the investment on the test equipment, the purchase process of the devices and the device stock. Comparison with the system on chip (SoC), the development period of the SIP is shorter, and the development cost is lower. Therefore, the present invention discloses a system on package, and more particularly is related to a package on package method, structure and associated PCB system.

### SUMMARY OF THE INVENTION

The invention is defined in claims 1, 8 and 11, respectively.

Particular embodiments are set out in the dependent claims.

The invention provides a package on package (PoP) method, comprising attaching a lead frame and a substrate, attaching an integrate circuit (IC) and the substrate and electrically connecting the IC and the lead frame, and packaging the IC, a part of the substrate and a part of the lead frame and exposing a surface mount (SMT) joint to form a concave package framework.

The invention further provides a package on package (PoP) structure, comprising a substrate, a lead frame, electrically connected to the substrate, an IC, attaching to the substrate and electrically connected to the lead frame, and a concave package, wherein the concave package is concave packaging a part of the substrate, a part of the lead frame and the IC, such that the substrate is exposed a SMT joint.

The invention further provides a PCB system, comprising a substrate, a lead frame, electrically connected to the substrate, a two-layer PCB, electrically connected to the lead frame, an IC, attaching to the substrate and electrically connected to the lead frame, and a concave package, wherein the concave package is packaging a part of the substrate, a part of the lead frame and the IC, such that the substrate exposes a SMT joint.

In an embodiment of the PoP stacking method the packaging of the component comprises packaging using the technique of: plastic quad flat package, ball grid array package, ceramic pin grid array package (CPGA), dual inline package, flip-chip pin grid array package (FCPGA), organic pin grid array package (OPGA), thin small outline package (TSOP), small outline J-lead package (SOJ), small outline integrated circuit (SOIC), shrink small-outline package (SSOP), thin quad flat pack (TQFP), plastic quad flat pack, wafer level chip scale package (WLCSP), mold array process-ball grid array package (MAPBGA), quad flat no-lead package (QFN), land grid array package (LGA) or pin grid array package. These packaging techniques are advantageously used in the PoP structure according to the invention or the PCB system according to the invention.

### BRIEF DESCRIPTION OF THE DRAWINGS

The present invention will become more readily apparent to those ordinarily skilled in the art after reviewing the following detailed description and accompanying drawings, in which:
- FIG. 1: shows a profile diagram of a conventional IC package;
- FIGS. 2 to 5: show package frameworks according to one embodiment of the present invention;

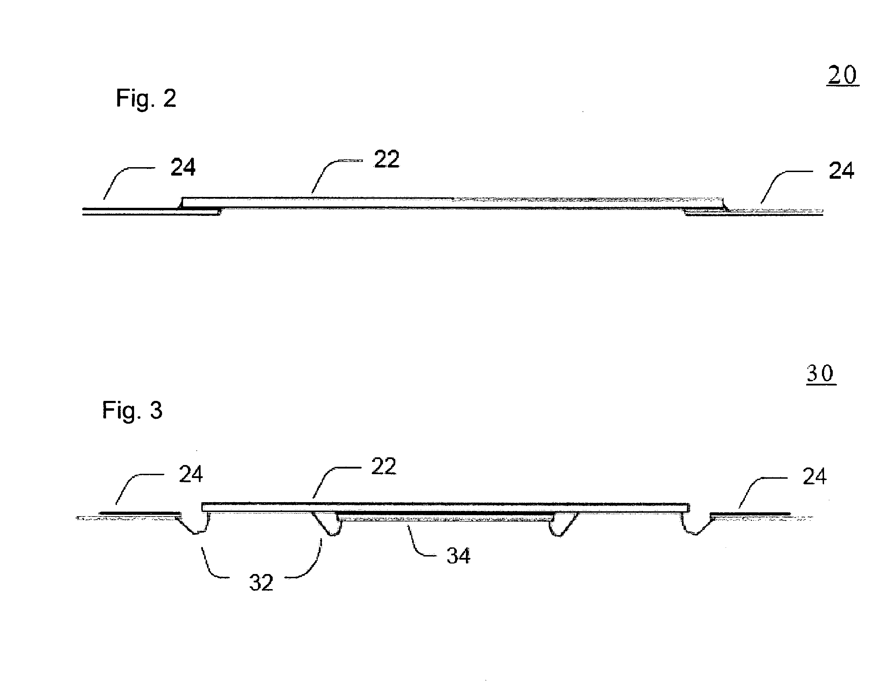

- FIG. 2: shows the framework of combining the substrate and the lead frame;
- FIG. 3: shows the framework after attaching an IC according to one embodiment of the present invention;

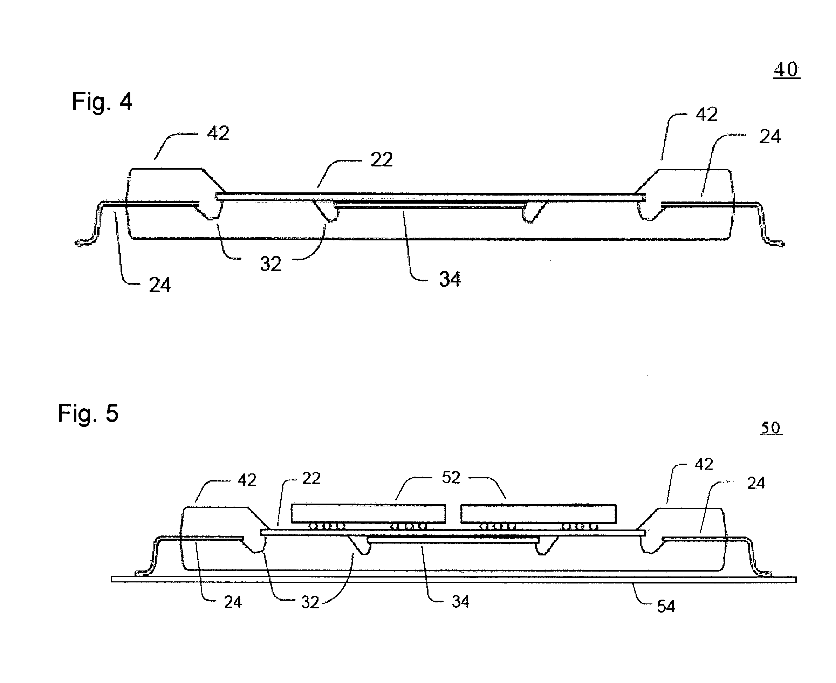

- FIG. 4: shows a concave package framework according to one embodiment of the present invention;
- FIG. 5: shows a PCB system according to one embodiment of the present invention; and

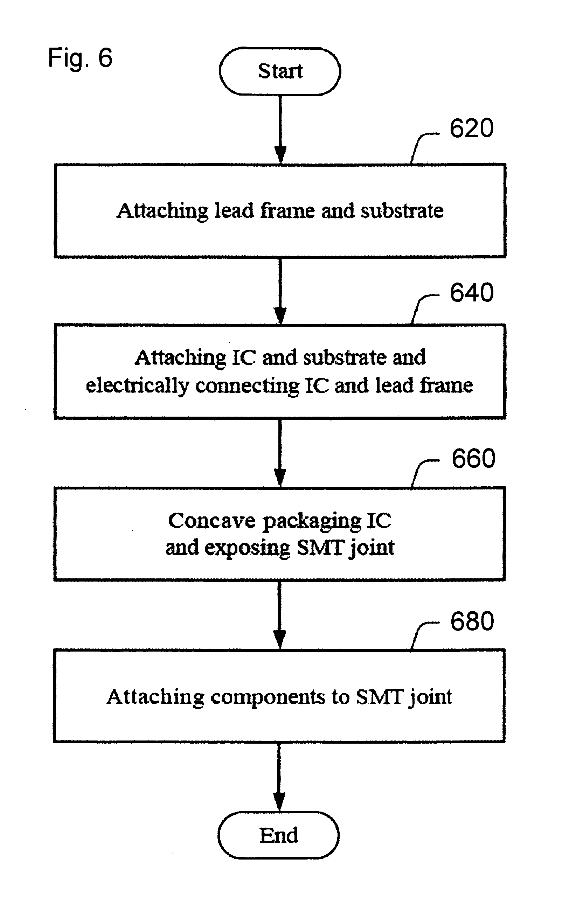

- FIG. 6: is a flowchart of a PoP method according to one embodiment of the present invention.

### DETAILED DESCRIPTION OF THE PREFERRED EMBODIMENT

With the popularity of the media products and the urgent demands for new storage configuration with more digits signal processing and more high storage capacity and flexibility, a stacked package on package (PoP) application grows rapidly. In an aspect of integrating complicated logic and memory, the PoP structure is a new and cost-effective 3D package solution. A system engineer can use the PoP structure to develop a new device figure, to integrate more semiconductors and to reduce the size of a printed circuit board (PCB) via the advantage of smaller volume by stacking.

The PoP structure can be accomplished by the cooperation of the original equipment manufacturer (OEM), logic and memory supplement manufacturer. The PoP structure solves the problem of affecting the high density logic and memory integration. Since the PoP technique in components in the end products of the OEM solves the high density integration problem, the PoP structure provides the optimal cost and reduces the yield reduction, test complexity and redundant stacking problem of the stacked ICs deployment and the testing devices process. Since the OEM has the PoP process, and the PoP structure permits that the logic and devices supplier uses the existent deployment, the test basis frame and process, the OEM can optimize manufacturing cost and ensure the flexibility of sources.

The system in package (SIP) combines the system on board and makes the system to a die, the SIP is a packaging technique having the advantage of the system on chip (SoC). Besides the feature of combining two or more than two ICs, the SIP has the feature of integrating the systems or subsystems with complete function in one package. Besides that the SIP can include one or more wires and ICs, separate passive devices can also be embedded in the package substrate, or other standard components assembled into the system substrate such as passive devices forming from material, surface acoustic wave (SAW) filter, electromagnetic interference (EMI) shield, capacitor, prepackaged IC, and the mechanical devices can also be embedded in the package substrate. Hence, the multilayered PCB can be reduced to the two-layered PCB or less to reduce the manufacturing cost of the system manufacturer.

FIGS. 2 to 5 show package frameworks according to one embodiment of the present invention. FIG. 2 shows the framework of combining the substrate and the lead frame. A combination framework 20 comprises a substrate 22 and a lead frame 24. First, the lead frame 24 and the substrate 22 are adhered or imprinted together. The lead frame 24 can be a metal lead frame.

FIG. 3 shows the framework after disposing an IC 34 according to one embodiment of the present invention. The framework 30 comprises the substrate 22, the lead frame 24, a connection wire 32 and an IC 34. The IC 34 and the substrate 22 are bonded, and the connection wire 32 electrically connects the IC 34 and the lead frame 24. Otherwise, the IC 34 can directly attach to the lead frame 24, and the invention is not limited to the methods of attaching two elements together. For example, the IC 34 can be an application-specific integrated circuit (ASIC) or a digital signal processor (DSP). The connection wire 34 can be a gold wire, a copper wire or a wire of other kinds of metal. The IC 34 can be any types of circuitries, and it is not limited to complementary metal-oxide-semiconductor (CMOS) or bipolar junction transistor (BJT).

FIG. 4 shows a concave package framework according to one embodiment of the present invention. The concave package framework 40 comprises the substrate 22, the lead frame 24, the connection wire 32, the IC 34 and a concave cover 42. FIG. 4 shows that the framework 30 in FIG. 3 is concave packaged. That is, a part of the substrate 22, a part of the lead frame 24, the IC 34 and the connection wire 32 are packaged except that a surface mount (SMT) joint is exposed, and the rest parts are packaged. Since the SMT joint is exposed (not covered), extra ICs or other components can be added. Preferably, the extra added component can be a device of a high speed transmission interface, such as a double-data-rate three synchronous dynamic random access memory (DDR3 SDRAM) or a serial advanced technology attachment (SATA) interface. In addition, the exposed SMT joint allows proceeding tests to the concave package framework 40, such as a power test, a grounding test or a functional test, so that the concave package frameworks 40 that fail the test(s) can be expelled to avoid more manufacturing cost on adding a well-functioned extra IC or other devices to the failed concave package framework 40. The concave package framework 40 can be formed by segmenting a plurality of concave package frameworks.

FIG. 5 shows a PCB system 50 according to one embodiment of the present invention. The PCB system 50 comprises the substrate 22, the lead frame 24, the connection wire 32, the IC 34, the concave cover 42, a component 52 and a PCB 54. First, the component 52 is tested. If the component 52 fails the test, the component 52 is expelled to prevent the concave package framework 40 from damage when attaching the unqualified components to the concave package framework 40, such that the manufacturing cost can be reduced. Then, the tested component 52 is attached to the SMT joint of the concave package framework 40 to form a stacking structure. The stacking structure is packaged to form a SIP structure, and then the SIP structure is tested. The SIP structure can be electrically connected with the PCB 54, preferably a two-layer PCB to provide further utility for the system manufacturer. Preferably, the component 52 has a high speed transmission interface, such as DDR3 SDRAM. It is noted that according to the present embodiment, the DDR3 SDRAM, supposed to be on the PCB, can be attached directly to the SMT joint of the concave package framework 40, resulting in the signal transmission quality with low inductance and low interference. So, the quality requirement of the PCB can be lower, and a low-cost two-layer PCB can be used. On the other hand, the embodiment has many advantages on the system production process. The embodiment of the present invention solves the problems raised from integration of high density logic and memory, and also it eliminates the problems of yield rate reduction, test complexity and redundant stacking in the stacking IC deployment and in the device testing process. The embodiment of the present invention allows the logic and devices suppliers use the existent arrangement, the test basis frame and process, hence the system manufacturer can optimize manufacturing cost, ensure the flexibility of sources and choose the device matching its demand without limiting to specific suppliers.

For example, the component 52 can be a passive component, memory or the device with high speed transmission interface. The package method can be plastic quad flat package, ball grid array package, ceramic pin grid array package (CPGA), dual inline package, flip-chip pin grid array package (FCPGA), organic pin grid array package (OPGA), thin small outline package (TSOP), small outline J-lead package (SOJ), small outline integrated circuit (SOIC), shrink small-outline package (SSOP), thin quad flat pack (TQFP), plastic quad flat pack, wafer level chip scale package (WLCSP), mold array process-ball grid array package (MAPBGA), quad flat no-lead package (QFN), land grid array package (LGA) or pin grid array package.

FIG. 6 is a flowchart of a PoP method according to one embodiment of the present invention. Step 620 is attaching a lead frame and a substrate. Attaching methods can be imprinting or adhering. Step 640 includes attaching an IC and the substrate and electrically connecting the IC and the lead frame. Step 660 includes concave packaging the IC and exposing a surface mount (SMT) joint, i.e., packaging a part of the substrate, a part of the lead frame, the IC and the connection wire, and exposing the SMT. Step 680 is attaching a component with the SMT joint.

While the invention has been described in terms of what is presently considered to be the most practical and preferred embodiments, it is to be understood that the invention needs not to be limited to the above embodiments. On the contrary, it is intended to cover various modifications and similar arrangements included within the spirit and scope of the appended claims which are to be accorded with the broadest interpretation so as to encompass all such modifications and similar structures.

## Claims

1. A package on package (PoP) stacking method, comprising:
attaching a lead frame (24) and a substrate (22);
attaching an integrated circuit (IC, 34) and the substrate (22) together and electrically connecting the IC (34) and the lead frame (24); and
packaging the IC (34), a part of the substrate (22) and a part of the lead frame (24);
and
exposing a surface mount (SMT) joint to form a concave package framework (40).

2. The method according to claim 1, further comprising attaching a component (52) to the SMT joint to form a stacking structure.

3. The method according to claim 2, further comprising packaging the stacking structure to form a system in package structure (SIP structure).

4. The method according to claim 3, further comprising testing the SIP structure.

5. The method according to claim 2, 3 or 4, further comprising testing the component (52).

6. The method according to any of the previous claims, further comprising testing the concave package framework (40).

7. The method according to any of the previous claims, further comprising electrically connecting the concave package framework (40) to a printed circuit board (PCB) (54), wherein in particular the PCB (54) is a two-layer PCB.

8. A package on package (PoP) structure, comprising:
a substrate (22);
a lead frame (24), electrically connected to the substrate;
an integrated circuit (34), attached to the substrate (22) and electrically connected to the lead frame (24); and
a concave package (42), concave packaging a part of the substrate (22), a part of the lead frame (24) and the integrated circuit (34), so as to provide an exposed surface mount (SMT) joint on the substrate.

9. The structure according to claim 8, further comprising a component (52) attached to the SMT joint.

10. The structure according to claim 8 or 9, wherein the integrated circuit (34) is connected to the lead frame (24) via a plurality of connection wires (32).

11. A printed circuit board (PCB) system, comprising:
a substrate (22);
a lead frame (24), electrically connected to the substrate (22);
a two-layer PCB (54), electrically connected to the lead frame (24);
an integrated circuit (34), attached to the substrate (22) and electrically connected to the lead frame (24); and
a concave package (42), packaging a part of the substrate (22), a part of the lead frame (24) and the integrated circuit (34), so as to provide an exposed SMT joint on the substrate.

12. The system according to claim 11, further comprising a component (52) attached to the SMT joint.

13. The method according to any of claims 2 to 7, the structure according to claim 9 or 10, or the system according to claim 12, wherein the component (52) has a high speed transmission interface and/or wherein the component (52) is a passive component or a memory.

14. The method according to any of claims 2 to 7 or 13, the structure according to claim 9, 10 or 13, or the system according to claim 12 or 13, wherein the package of the component (52) comprises: plastic quad flat package, ball grid array package, ceramic pin grid array package (CPGA), dual inline package, flip-chip pin grid array package (FCPGA), organic pin grid array package (OPGA), thin small outline package (TSOP), small outline J-lead package (SOJ), small outline integrated circuit (SOIC), shrink small-outline package (SSOP), thin quad flat pack (TQFP), plastic quad flat pack, wafer level chip scale package (WLCSP), mold array process-ball grid array package (MAPBGA), quad flat no-lead package (QFN), land grid array package (LGA) or pin grid array package.
